# EUROPÄISCHE PATENTSCHRIFT

(11) **EP 0 921 572 B1**
(45) Veröffentlichungstag und Bekanntmachung des Hinweises auf die Patenterteilung: **14.07.2010**
(21) Anmeldenummer: 98115293.7
(22) Anmeldetag: 13.08.1998
(51) Int. Cl.: H01L 27/108, H01L 21/8242, H01L 21/3205

(54) **Verfahren zur Herstellung einer DRAM-Zelle mit Kondensator in separatem Substrat**
Method of forming DRAM cell having capacitor in separate substrate
Procédé de formation d'une cellule DRAM ayant la capacité dans un substrat séparé

(30) Priorität: 21.10.1997 DE 19746416
(43) Veröffentlichungstag der Anmeldung: 09.06.1999
(73) Patentinhaber: Infineon Technologies AG, 85579 Neubiberg (DE)
(72) Erfinder: Klose, Helmut, New York 12603 (US); Lehmann, Volker, 80689 München (DE); Reisinger, Hans, 82031 Grünwald (DE); Hoenlein, Wolfgang, 82008 Unterhaching (DE)
(74) Vertreter: Barth, Stephan Manuel

(56) Entgegenhaltungen:
- US-A- 5 241 201
- PATENT ABSTRACTS OF JAPAN vol. 18, no. 231 (E-1538), 15. April 1994 & JP 06 013547 A (NEC CORP), 21. Januar 1994
- V. LEHMANN ET AL.: "SIKO - A new Capacitor Technology based on Porous Silicon" CARTS EUROPE 95,1995, Seiten 107-109, XP000749918
- LEHMANN V: "POROUS SILICON - A NEW MATERIAL FOR MEMS" PROCEEDINGS OF THE 9TH. ANNUAL INTERNATIONAL WORKSHOP ON MICRO ELEC MECHANICAL SYSTEMS, INVESTIGATION OF MICRO STRUCTURES, SENSORS, ACTUATORS, MACHINES AND SYSTEMS. SAN DIEGO, FEB. 11 - 15, 1996, Nr. WORKSHOP 9, 11. Februar 1996, Seiten 1-6, XP000689241 INSTITUTE OF ELECTRICAL AND ELECTRONICS ENGINEERS
- HAYASHI Y ET AL: "FABRICATION OF THREE-DIMENSIONAL IC USING "CUMULATIVELY BONDED IC" (CUBIC) TECHNOLOGY" SYMPOSIUM ON VLSI TECHNOLOGY, HONOLULU, JUNE 4 - 7, 1990, Nr. SYMP. 10, 4. Juni 1990, Seiten 95-96, XP000164428 INSTITUTE OF ELECTRICAL AND ELECTRONICS ENGINEERS

## Beschreibung

Die vorliegende Erfindung betrifft ein Verfahren zur Herstellung einer integrierten Schaltungsanordnung mit einer Mehrzahl von Kondensatoren.

Aus der JP 63 151071 A ist eine integrierte Schaltungsordnung bekannt, bei der in einem ersten Substrat eine Mehrzahl von Kondensatoren vorgesehen ist, welche über eine Oberfläche des ersten Substrats mit einem Kontakt eines zweiten Substrats verbunden sind.

V. Lehmann et al. "SIKO - A new Capacitor Technology based on Porous Silicon" CARTS EUROPE 95, 1995, Seiten 107-109, XP000749918 sowie Lehmann V. POROUS SILICON - A NEW MATERIAL FOR MEMS" PROCEEDINGS OF THE 9TH: ANNUAL INTERNATIONAL WORKSHOP ON MICRO ELEC MECHANICAL SYSTEMS, INVESTIGATION OF MICRO STRUCTURES, SENSORS, ACTUATORS, MACHINES AND SYSTEMS. SAN DIEGO, FEB. 11 - 15, 1996, Nr. WORKSHOP 9, 11. Februar 1996 offenbaren Strukturen, bei denen in einem Substrat Teilkondensatoren durch eine Porenätzung, ein anschließendes Vorsehen eines Dielektrikums und eine Füllung der Poren vorgesehen sind.

Die JP 06013547 A offenbart die Bildung von Poren in Silizium durch ein elektrochemisches Ätzverfahren.

Bei der Entwicklung neuer integrierter Schaltungsanordnungen wird eine erhöhte Packungsdichte angestrebt. Die Realisierung erfolgt derzeit meist in einer planaren Siliziumtechnologie.

Eine Möglichkeit, die Packungsdichte zu erhöhen, besteht darin, einen Kondensator einer Schaltungsanordnung nicht planar, sondern in einem Graben zu realisieren (siehe z.B. P. Chatterjee et al. IEDM 86 Seiten 128-131). Der Graben wird durch ein fotolithografisches Verfahren in einem Halbleitersubstrat, in dem die Schaltungsanordnung, angeordnet ist, erzeugt. Bei Strukturgrößen unter 200nm wird dieses Konzept problematisch, da bei der Erzeugung der Grabenstruktur oft Kantenversetzungen entstehen, entlang denen sich leitende Kanäle ausbilden und die sich durch benachbarte Bauelemente der Schaltungsanordnung hindurchziehen. Außerdem entstehen Probleme bei der Herstellung des Grabens aufgrund der extremen Unterschiede zwischen Kondensatorbreite und Kondensatortiefe.

In Y. Kawamoto et al., "A 1,28µm2 Bit-Line Shielded Memory Cell Technology for 64mbit DRAM's", Techn. Digest of VLSI Symposium 1990, Seite 13 wird vorgeschlagen einen Kondensator als Stapelkondensator zu bilden. Zur Vergrößerung einer Oberfläche und damit der Kapazität des Speicherkondensators wird eine relativ komplizierte Struktur aus Polysilizium benötigt, die umso schwieriger herstellbar ist, je höher die Packungsdichte ist.

Bei der Erzeugung von Bauelementen durch fotolithografische Verfahren, ist der Packungsdichte zum einen durch die minimale, in der jeweiligen Technologie herstellbaren Strukturgröße F und zum anderen durch Ungenauigkeiten der Justierung, die etwa ca. 1/3 F betragen, eine Grenze gesetzt. Zur weiteren Vergrößerung der Packungsdichte wurde in z. B. DE 195 19 160 vorgeschlagen, Bauelemente einer DRAM-Zellenanordnung selbstjustiert, d. h. ohne Verwendung von zu justierenden Masken, erzeugen.

In V. Lehmann, Material Letters 28 (1996) Seiten 245-249 wird die Erzeugung von Kondensatoren in einem Siliziumsubstrat beschrieben. Dazu werden im Siliziumsubstrat durch ein fotolithografisches Verfahren Kerben erzeugt, aus denen durch anschließendes elektrochemisches Ätzen Poren erzeugt werden. Die Poren werden anschließend mit einem Kondensatordielektrikum und mit Speicherknoten versehen.

Aus Y. Hayashi et al., Sypm. on VLSI Techn. (1990), Seite 95 bis 96, ist bekannt, Substrate, die Bauelemente umfassen, durch eine Klebeschicht aus Polyimid zu verbinden. Kontakte zwischen den Substraten werden über Wolframstifte und zugehörige großflächige Vertiefungen, die mit einer Au/In-Legierung gefüllt werden, realisiert.

Der Erfindung liegt das Problem zugrunde, ein Herstellungsverfahren für eine integrierte Schaltungsanordnung mit einer Mehrzahl von Kondensatoren anzugeben, die mit besonders hoher Packungsdichte einfach herstellbar ist.

Dieses Problem wird gelöst durch ein Verfahren gemäß Anspruch 1. Weitere Ausgestaltungen der Erfindung gehen aus den übrigen Ansprüchen hervor.

Die Justiertoleranz beim Kontaktieren der Kondensatoren, d. h. beim Verbinden der Substrate, kann ohne Verkleinerung der Packungsdichte vergrößert werden, wenn erst die Kontaktierung festlegt, welcher der Teilkondensatoren die Kondensatoren bilden. Dazu ist die Kontaktfläche in mindestens einer Dimension auch größer als ein Abstand zwischen einem der Teilkondensatoren und einem Rand des Gebiets. In diesem Fall muss die Kontaktfläche in jedem Fall muss die Kontaktfläche nicht in einem bestimmten Teil sondern kann in einem beliebigen Teil des Gebiets angeordnet werden, da die Kontaktfläche in jedem Fall an mindestens einen der Teilkondensatoren, der dann einen Kondensator definiert, angrenzt. Je größer das Gebiet ist, umso größer ist die Justiertoleranz. Die Verbindung des ersten Substrats mit dem zweiten Substrat kann im wesentlichen unjustiert erfolgen, wenn die Teilkondensatoren auf einem ersten Substrat derart verteilt sind und eine Kontaktfläche des Kontakts so groß ist, dass beim Verbinden der Substrate jeder Kontakt in jedem Fall an mindestens einen der Teilkondensatoren angrenzt, der dann den zugehörigen Kondensator definiert.

Die Packungsdichte wird umso höher je dichter die Teilkondensatoren beieinander liegen und je kleiner die Kontaktfläche ist. Eine hohe Justiertoleranz und eine hohe Packungsdichte läßt sich demnach erzielen, wenn das Gebiet groß ist, in dem Gebiet viele Teilkondensatoren mit kleinen Abständen voneinander angeordnet sind und die Dimension des Querschnitts der Kontaktfläche nur wenig größer als die Abstände ist. In diesem Fall sind Abstände zwischen dem Rand des Gebiets und dazu benachbarten Teilkondensatoren vorzugsweise nicht größer als der Abstand zwischen zueinander benachbarten Teilkondensatoren.

Es ist vorteilhaft, wenn der Kondensator mehr als einen Teilkondensator umfaßt. Dadurch wird eine Oberfläche und damit die Kapazität des Kondensators vergrößert. Die Kontaktfläche ist in diesem Fall dementsprechend größer. Die Justiertoleranz läßt sich auch hier vergrößern, wenn die Kontaktfläche in mindestens einer Dimension auch größer als der doppelte Abstand zwischen einem der Teilkondensatoren und einem Rand des Gebiets ist, und wenn die Kontaktfläche innerhalb des Gebiets des ersten Substrats angeordnet wird.

Die Schaltungsanordnung kann beispielsweise eine DRAM-Zellenanordnung sein. Auf dem zweiten Substrat sind dann Auswahltransistoren, deren zweite Source/Drain-Gebiete mit Bitleitungen und deren Gateelektroden mit quer zu den Bitleitungen verlaufenden Wortleitungen verbunden sind. Auf ersten Source/Drain-Gebieten werden die Kontakte angeordnet. Zur Vergrößerung der Packungsdichte können die Auswahltransistoren vertikal ausgebildet sein. Die Wortleitungen können als Spacer ausgebildet sein. In diesem Fall kann eine Fläche einer Speicherzelle 4F² oder kleiner sein.

Die Teilkondensatoren können regelmäßig, unregelmäßig und/oder mit kurzreichweitiger Ordnung über das Gebiet verteilt sein.

Zur Herstellung der Teilkondensatoren kann das erste Substrat aus Halbleitermaterial bestehen, das elektrochemisch geätzt wird. Die dabei entstehenden Poren werden mit einem Kondensatordielektrikum versehen. Zur Erzeugung von Speicherknoten der Teilkondensatoren wird leitendes Material aufgebracht. Die Speicherknoten der Teilkondensatoren können voneinander isoliert werden, indem das leitende Material strukturiert wird.

Beim elektrochemischen Ätzen kann das Substrat als positiv gepolte Elektrode einer, ein flußsäurehaltiges Medium enthaltenden Elektrolysierzelle geschaltet sein. Durch Anlegen eines Potentials entstehen Poren im ersten Substrat. Die Teilkondensatoren werden in den Poren realisiert. Je nach Stromstärke und Dotierstoffkonzentration des ersten Substrats sind die Poren zwischen 10nm und 100nm weit, und regelmäßig oder unregelmäßig angeordnet. Abstände zwischen zueinander benachbarten Teilkondensatoren können in etwa gleich groß sein. Dies ist beispielsweise der Fall in einem n-dotierten Substrat bei einer Stromdichte von ca. 100mA/cm² und einer Dotierstoffkonzentration von ca. 10¹⁸cm⁻³. Sowohl etwa gleiche Abstände zwischen den Teilkondensatoren als auch eine räumlich regelmäßige Anordnung der Teilkondensatoren erhält man, wenn das erste Substrat vorstrukturiert wird. Dazu werden z.B. regelmäßig angeordnete kleine Kerben in dem ersten Substrat erzeugt, die die räumliche Anordnung der Poren festlegt. Die Poren entstehen an den Stellen, an denen die Kerben erzeugt wurden. Die Kerben können z.B. durch ein fotolithografisches Verfahren erzeugt werden. Es können dabei auch Interferenzerscheinungen von monochromatischem kohärentem Licht ausgenutzt werden.

Werden das erste Substrat und das zweite Substrat mit einer großen Justiertoleranz miteinander verbunden und sind die Teilkondensatoren unregelmäßig aber mit etwa gleich großen Abständen voneinander angeordnet, so ist es vorteilhaft, wenn die Kontaktfläche etwa 10 mal so groß ist, wie der Abstand zwischen Mitten zueinander benachbarter Teilkondensatoren. Da die Abweichung der Anzahl der Teilkondensatoren eines Kondensators bei gleichen Abständen der Teilkondensatoren nur etwa 1 beträgt, läßt sich dadurch die Kapazität des Kondensators relativ genau festlegen.

Das Verbinden des ersten Substrats mit dem zweiten Substrat kann z.B. eutektisch erfolgen. Dazu wird für die Kontaktfläche z.B. Gold auf den Kontakt und/oder dem Speicherknoten aufgebracht. Anschließend wird das erste Substrat und das zweite Substrat zusammengefügt und auf ca. 400 bis 500°C erhitzt, wodurch das erste Substrat mit dem zweiten Substrat fest verbunden wird.

Das Kondensatordielektrikum kann z.B. aus einer ONO-Schicht bestehen. Dabei steht O für Siliziumoxid und N für Siliziumnitrid. Es sind jedoch auch andere dielektrische Materialien, wie z.B. Keramiken, denkbar.

Zur Erhöhung der Kapazität des Kondensators, ist es vorteilhaft, wenn das erste Substrat in einer an die Oberfläche des ersten Substrats angrenzenden Schicht hochdotiert ist. Die Schicht kann z.B. durch Implantation erzeugt werden. Alternativ kann nach Erzeugung der Poren eine Diffusionsquelle abgeschieden werden, aus der durch Tempern Dotierstoff in das Substrat diffundiert. Die Dotierstoffquelle kann anschließend entfernt werden, worauf die Erzeugung des Kondensatordielektrikums erfolgen kann. Als Dotierstoffquelle ist z.B. Phosphorsilikatglas geeignet.
Als leitendes Material für den Speicherknoten läßt sich z.B. dotiertes Polysilizium verwenden. Zur Isolation der Speicherknoten voneinander kann das Polysilizium anschließend chemisch-mechanisch poliert und/oder rückgeätzt werden. Durch anschließendes epitaktisches Aufwachsen können die Speicherknoten jenseits der Oberfläche des ersten Substrats vergrößert werden, was die Verbindung zur Kontaktfläche erleichtert.

Im folgenden wird ein Ausführungsbeispiel der Erfindung, das in den Figuren dargestellt ist, näher erläutert.
- Figur 1: zeigt ein erstes Substrat, nachdem durch elektroche- misches Ätzen Poren erzeugt wurden.
- Figur 2: zeigt das erste Substrat, nachdem eine Schicht und ein Kondensatordielektrikum erzeugt wurden, und eine dotierte Polysiliziumschicht abgeschieden wurde.
- Figur 3: zeigt das erste Substrat, nachdem Speicherknoten er- zeugt wurden, indem die dotierte Polysiliziumschicht rückgeätzt und anschließend epitaktisch aufgewachsen wurde.
- Figur 4: zeigt einen Ausschnitt aus einer Aufsicht auf ein zweites Substrat, nachdem Auswahltransistoren, Wort- leitungen, Bitleitungen und Kontakte erzeugt wurden.
- Figur 5: zeigt einen Querschnitt durch das erste Substrat und das zweite Substrat, nachdem das erste Substrat mit dem zweiten Substrat unjustiert miteinander verbunden wurden.

Die Figuren sind nicht maßstäblich.

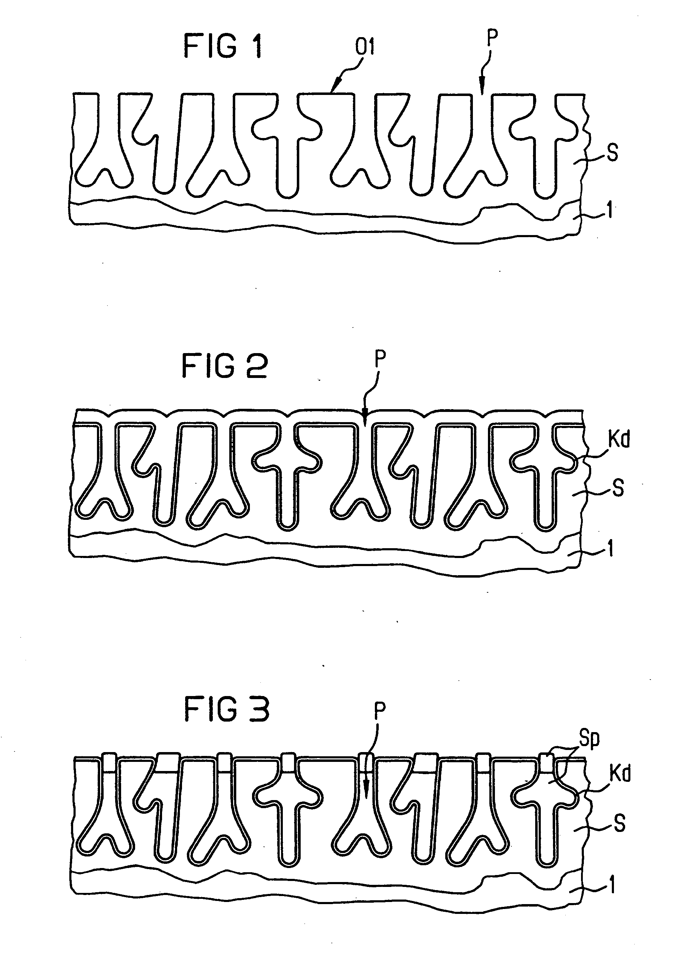

In einem Ausführungsbeispiel enthält ein erstes Substrat 1 n-dotiertes Silizium. Die Dotierstoffkonzentration des Siliziums beträgt ca. 10¹⁸cm⁻³. Das erste Substrat 1 wird mit einem ersten Spannungsanschluß verbunden und in eine Flußsäurelösung (25 Gewichtsprozent) getaucht. In der Flußsäurelösung befindet sich eine Elektrode, die mit einem zweiten Spannungsanschluß verbunden ist. Anschließend wird eine Spannung zwischen dem ersten Spannungsanschluß und dem zweiten Spannungsanschluß erzeugt, die ca. 2 Volt beträgt. Die Spannungsdifferenz zwischen dem ersten Spannungsanschluß und dem zweiten Spannungsanschluß ist positiv. Die entstehende Stromdichte beträgt ca. 100mA/cm². Nach einigen Minuten entstehen ca. 100nm breite und einige µm tiefe Poren P im ersten Substrat 1. Nach Erreichen der gewünschten Porentiefe wird die elektrochemische Ätzung beendet. Abstände zwischen Mitten zueinander benachbarter Poren P sind etwa gleich und betragen ca. 20 nm (siehe Figur 1). Die Poren P sind räumlich nicht regelmäßig angeordnet.

Zur Erzeugung einer hochdotierten Schicht S, wird als Dötierstoffquelle Phosphorsilikatglas in einer Dicke von einigen nm auf eine Oberfläche O1 des ersten Substrats 1 abgeschieden. Anschließend wird durch Tempern Dotierstoff aus dem Phorphorsilikatglas etwa 100 nm tief in das erste Substrat 1 ausdiffundiert, wodurch die Schicht S entsteht. Die Schicht S ist n-dotiert und ihre Dotierstoffkonzentration beträgt ca. 10²⁰cm⁻³. Die Schicht S ist als Kondensatorplatte von Kondensatoren geeignet.

Anschließend wird das Phosphorsilikatglas entfernt. Als Ätzmittel ist z.B. HF geeignet.

Zur Erzeugung eines Kondensatordielektrikums Kd, wird eine ONO-Schicht erzeugt. Dabei steht O für Siliziumoxid und N für Siliziumnitrid. Dazu wird zunächst durch thermische Oxidation eine ca. 2nm dicke Siliziumoxidschicht aufgewachsen. Anschließend wird ca. 4nm Siliziumnitrid abgeschieden, das ca. 2nm tief aufoxidiert wird (siehe Figur 2).

Zur Erzeugung von Speicherknoten Sp von Teilkondensatoren, wird anschließend dotiertes Polysilizium in einer Dicke von 5nm abgeschieden (siehe Figur 2). Durch Rückätzen werden die Speicherknoten Sp verschiedener Teilkondensatoren voneinander isoliert (s. Figur 3). Dabei wird das Kondensatordielektrikum Kd teilweise freigelegt. Anschließend werden die Speicherknoten Sp durch selektive Epitaxie bis jenseits der Oberfläche O1 des ersten Substrats 1 verlängert (siehe Figur 3).

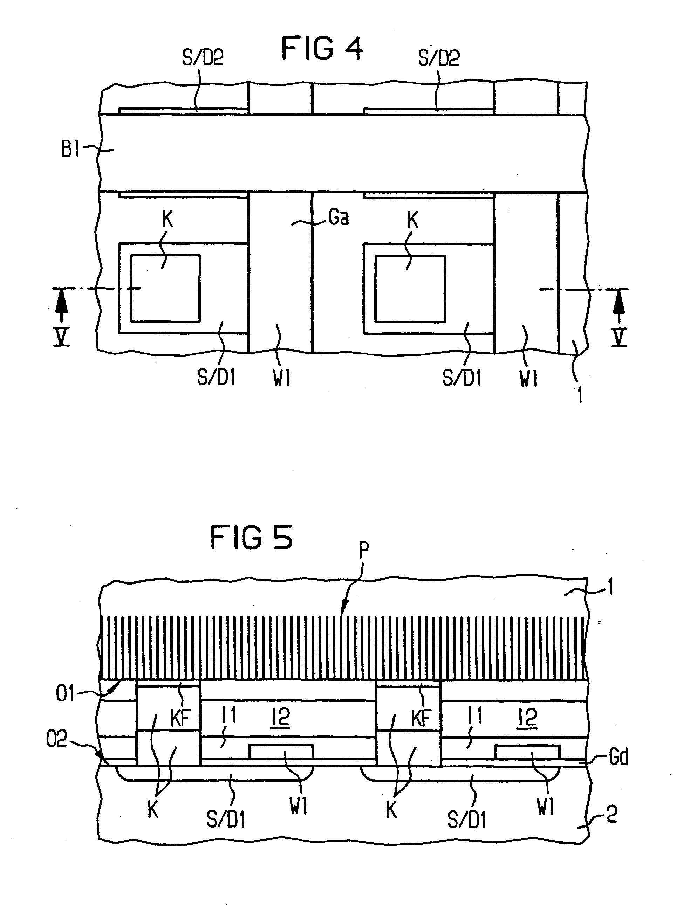

In einem zweiten Substrat 2 werden Auswahltransistoren, Wortleitungen und Bitleitungen erzeugt (siehe Figur 4). Die Auswahltransistoren sind z.B. planare Transistoren. Sie können aber auch z.B. vertikale Transistoren sein. Erste Source/Drain-Gebiete S/D1 von den Auswahltransistoren werden mit Kontakten K versehen. Die Kontakte K umfassen z.B. 100 nm dotiertes Polysilizium und 200nm Wolfram. Zweite Source/Drain-Gebiete S/D2 der Auswahltransistoren werden mit den Bitleitungen Bl verbunden. Die Bitleitungen Bl verlaufen quer zu den Wortleitungen Wl. Gateelektroden Ga der Auswahltransistoren grenzen an ein Gatedielektrikum Gd an und werden mit den Wortleitungen Wl verbunden. Die Wortleitungen Wl werden z.B. durch eine erste isolierende Struktur I1 aus Siliziumnitrid bedeckt. Die Wortleitungen Wl und die Bitleitungen Bl enthalten z.B. Polysilizium, MoSi und/oder Aluminium.

Zur Erzeugung einer ca. 500nm dicken zweiten isolierenden Struktur I2 wird *SiO*₂ in einer Dicke von ca. 500nm abgeschieden, durch chemisch-mechanisches Polieren planarisiert, bis Kontaktflächen KF der Kontakte K freigelegt werden, und rückgeätzt. Die zweite isolierende Struktur I2 schützt Teile der Schaltungsanordnung, die sich auf dem zweiten Substrat 2 befinden.

Anschließend werden die Kontaktflächen KF der Kontakte K vergoldet. Das erste Substrat 1 und das zweite Substrat 2 werden unjustiert miteinander verbunden, indem das erste Substrat 1 und das zweite Substrat 2 zusammengefügt und auf ca. 400 bis 500°C erhitzt werden (siehe Figur 5).

## Patentansprüche

1. Verfahren zur Herstellung einer integrierten Schaltungsanordnung mit einer Mehrzahl von Kondensatoren, wobei
- in einem an eine Oberfläche (O1) eines ersten Substrats (1) angrenzenden Gebiet des ersten Substrats (1) eine Mehrzahl von Teilkondensatoren gebildet wird,
- zur Bildung der Teilkondensatoren Poren (P) durch elektrochemisches Ätzen in der Oberfläche (O1) erzeugt werden, die Poren (P) mit einem Kondensatordielektrikum (Kd) versehen werden und zur Erzeugung von Speicherknoten (Sp) der Teilkondensatoren leitendes Material in den Poren (P) vorgesehen wird;
- im Bereich einer Oberfläche (02) eines zweiten Substrats (2) eine Mehrzahl von Kontakten (K) mit einer jeweiligen Kontaktfläche (KF) gebildet wird, deren zur Oberfläche (O1) des ersten Substrats (1) paralleler Querschnitt in mindestens einer Dimension grösser als ein Abstand der Teilkondensatoren ist; und
- das erste und das zweite Substrat (1, 2) derart unjustiert miteinander verbunden werden, dass die Kontaktflächen (KF) an mindestens einen jeweiligen Speicherknoten (Sp) eines Teilkondensators angrenzen, wodurch jeder Kondensator durch den oder die Teilkondensatoren gebildet wird, deren Speicherknoten (SP) an eine betreffende Kontaktfläche (KF) angrenzen.

2. Verfahren nach Anspruch 1, wobei
- im ersten Substrat (1) das Halbleitermaterial eine erste Dotierstoffkonzentration enthält, nach Erzeugung der Poren (P) eine Dotierstoffquelle abgeschieden wird; und
- durch Tempern Dotierstoff der Dotierstoffquelle in das erste Substrat (1) diffundiert, wodurch innerhalb des ersten Substrats (1) eine Schicht (S) mit einer zweiten Dotierstoffkonzentration entsteht.

3. Verfahren nach Anspruch 1 oder 2, wobei
vor Erzeugung der Poren (P) das erste Substrat (1) vorstrukturiert wird, wodurch die räumliche Anordnung der Poren (P) vorgegeben wird.

4. Verfahren nach einem der Ansprüche 1 bis 3, wobei
das erste Substrat (1) und das zweite Substrat (2) eutektisch verbunden werden.

5. Verfahren nach Anspruch 4, wobei
- die Kontaktflächen (KF) und/oder Speicherknoten (Sp) mit Gold versehen werden; und
- das erste Substrat (1) und das zweite Substrat (2) zusammengefügt und auf ca. 400°C-500°C erhitzt werden.

6. Verfahren nach einem der Ansprüche 1 bis 5,
- bei dem die Kondensatoren aus mindestens fünf der Teilkondensatoren gebildet werden.

7. Verfahren nach einem der Ansprüche 1 bis 6, wobei
eine DRAM-Zellenanordnung hergestellt wird.

## Claims

1. Method for producing an integrated circuit arrangement comprising a plurality of capacitors, wherein
- a plurality of partial capacitors are formed in a region of a first substrate (1) which adjoins a surface (01) of the first substrate (1),
- in order to form the partial capacitors, pores (P) are produced by electrochemical etching in the surface (01), the pores (P) are provided with a capacitor dielectric (Kd) and, in order to produce storage nodes (Sp) of the partial capacitors, conductive material is provided in the pores (P);
- in the region of a surface (02) of a second substrate (2), a plurality of contacts (K) with a respective contact area (KF) are formed, the cross section of which parallel to the surface (01) of the first substrate (1) in at least one dimension is larger than a distance between the partial capacitors; and
- the first and the second substrates (1, 2) are connected to one another in an unaligned fashion in such a way that the contact areas (KF) adjoin at least one respective storage node (Sp) of a partial capacitor, as a result of which each capacitor is formed by the partial capacitor or partial capacitors whose storage nodes (Sp) adjoin a relevant contact area (KF).

2. Method according to Claim 1, wherein
- in the first substrate (1) the semiconductor material contains a first dopant concentration, a dopant source is deposited after the pores (P) have been produced; and
- by means of heat treatment, dopant of the dopant source diffuses into the first substrate (1), as a result of which a layer (S) having a second dopant concentration arises within the first substrate (1).

3. Method according to Claim 1 or 2, wherein
before the pores (P) are produced, the first substrate (1) is prepatterned, as a result of which the spatial arrangement of the pores (P) is predefined.

4. Method according to any of Claims 1 to 3, wherein
the first substrate (1) and the second substrate (2) are connected eutectically.

5. Method according to Claim 4, wherein
- the contact areas (KF) and/or storage nodes (Sp) are provided with gold; and
- the first substrate (1) and the second substrate (2) are joined together and heated to approximately 400°C-500°C.

6. Method according to any of Claims 1 to 5,
- wherein the capacitors are formed from at least five of the partial capacitors.

7. Method according to any of Claims 1 to 6, wherein
a DRAM cell arrangement is produced.

## Revendications

1. Procédé de fabrication d'un circuit intégré avec une multiplicité de condensateurs, selon lequel
- une pluralité de condensateurs partiels est formée dans une zone d'un premier substrat (1) qui est adjacente à une surface (01) du premier substrat (1) ;
- une pluralité de condensateurs partiels, des pores (P) sont produits par gravure électrochimique dans la surface (01), les pores (P) sont munis d'un diélectrique de condensateur (Kd) et, pour la production de noeuds de stockage (Sp) des condensateurs partiels, un matériau conducteur est prévu dans les pores (P) ;
- dans la zone d'une surface (02) d'un deuxième substrat (2) une pluralité de contacts (K) est formée avec une surface de contact respective (KF) dont la section transversale parallèle à la surface (01) du premier substrat (1) est, dans au moins une dimension, plus grande qu'une distance entre condensateurs partiels ; et
- le premier et le deuxième substrat (1, 2) sont reliés de manière non justifiée de telle sorte que les surfaces de contact (KF) sont adjacentes à au moins un noeud de stockage respectif (Sp) d'un condensateur partiel, de sorte que chaque condensateur est formé par le ou les condensateurs partiels dont les noeuds de stockage (SP) sont adjacents à une surface de contact (KF) considérée.

2. Procédé selon la revendication 1, selon lequel
- dans le premier substrat (1), le matériau semiconducteur contient une première concentration d'agent dopant, une source d'agent dopant est déposée après production des pores (P) ; et
- par traitement thermique, de l'agent dopant de la source d'agent dopant diffuse dans le premier substrat (1), ce qui crée à l'intérieur du premier substrat (1) une couche (S) avec une deuxième concentration d'agent dopant.

3. Procédé selon la revendication 1 ou 2, selon lequel le premier substrat (1) est structuré au préalable avant la production des pores (P), ce qui fait que l'agencement spatial des pores (P) est prédéterminé.

4. Procédé selon l'une des revendications 1 à 3, selon lequel le premier substrat (1) et le deuxième substrat (2) sont reliés de manière eutectique.

5. Procédé selon la revendication 4, selon lequel
- les surfaces de contact (KF) et/ou les noeuds de stockage (Sp) sont munis d'or; et
- le premier substrat (1) et le deuxième substrat (2) sont joints et chauffés à environ 400 °C à 500 °C.

6. Procédé selon l'une des revendications 1 à 5, selon lequel les condensateurs sont formés à partir d'au moins cinq des condensateurs partiels.

7. Procédé selon l'une des revendications 1 à 6, selon lequel un agencement de cellules DRAM est fabriqué.
